Europäisches Patentamt

(19) European Patent Office  (11) Publication number: **0 064 627**

Office européen des brevets  **B1**

(12) **EUROPEAN PATENT SPECIFICATION**

(45) Date of publication of patent specification: **28.11.84**  (51) Int. Cl.³: **H 03 K 13/24**

(21) Application number: **82103358.6**

(22) Date of filing: **21.04.82**

(54) **Keyboard coding apparatus.**

(30) Priority: **07.05.81 IT 2153981**

(43) Date of publication of application:
**17.11.82 Bulletin 82/46**

(45) Publication of the grant of the patent:
**28.11.84 Bulletin 84/48**

(84) Designated Contracting States:
**CH DE FR GB LI NL**

(56) References cited:
**DE-A-2 420 119**
**US-A-3 750 113**
**US-A-4 222 038**

**IBM TECHNICAL DISCLOSURE BULLETIN, vol.
23, August 1980; pages 914-916; New York,
US, S.M. BELYEU et al.: "Controller interface
for remote switch matrix"
ELECTRONICS INTERNATIONAL, vol 50, no. 10,
May 12, 1977, pages 109-113; New York, US,
D.W. SOHN et al.: "Third-generation
microcomputer set packs it all into 3 chips"**

(73) Proprietor: **HONEYWELL INFORMATION
SYSTEMS ITALIA S.p.A.
Via Martiri d'Italia 3
I-10014 Caluso (Torino) (IT)**

(72) Inventor: **Vercesi, Arturo
Via Virgilio 64
I-20017 Rho (MI) (IT)**
Inventor: **Marzocca, Francesco
Via Millelire 16
I-20100 Milano (IT)**

Courier Press, Leamington Spa, England.

# Description

The present invention relates to a keyboard coding apparatus which associates a coded information to each key of a keyboard, when such key is actuated, the code being related to the selected alphanumeric or control character.

It is known that a keyboard is one of the simplest and most usual devices for loading information into data processing systems.

At present, like every else input/output device, a keyboard is connected to the central unit of the equipment of which it is part through an interface unit.

Generally such interface unit, suitably commanded by the central unit, verifies according to a predetermined sequence if there is a key actuated. If the interface unit detects an actuated key, it takes the code representative of the alphanumeric or control character related to such actuated key and makes available on its output such coded information.

The keyboard and the interface unit form a unitary element or peripheral unit physically separated from the central unit. The connection between the keyboard interface unit and the central unit generally occurs through a group of leads or BUS.

Particularly it is possible to distinguish two groups of leads=a first group of leads is devoted to transmit character codes from interface unit to central unit; a second group of leads is devoted to exchange control signals between central unit and keyboard interface unit.

A keyboard interface unit as the one above mentioned is provided by INTEL in form of integrated circuit with code 8278.

Further keyboard interface unit are described in numerous patents, as for instance U.S. patents N. 4,222,038 and N. 4,106,011.

However, both the use of the keyboard interface circuits of the above mentioned patents and the use of integrated circuit 8278 weigh heavily on the total cost of the equipment of which the keyboard is part.

Besides, both the keyboard interface units of the above mentioned patents and the keyboard interface 8278 require a high number of leads to be connected to the central unit for the exchange of data/commands/control signals.

More in detail the already mentioned U.S. Patent 4,222,038 describes a keyboard interface unit for connection to a microprocessor bus, the interface unit including a peripheral interface adapter a counter/decoder and a set of transmission gates.

The peripheral interface adapter, typically a circuit manufactured by the U.S. firm Motorola with code MC6820, communicates with a microprocessor or central control unit, through the microprocessor address and the data bus and involves the use of a high number of connection leads.

The peripheral interface adapter further controls the status of the counter decoder by means of a clock signal and receives from the set of transmission gates a multiple bit binary code generated by the keyboard matrix.

Wherever an interface is established and a cable connection is provided the number of required leads is significantly high because a multiple bit binary code has to be parallel transferred on several leads.

The same limitation is present in the Controller interface for remote switch matrix described in the IBM Technical Disclosure bulletin, Vol. 23, N. 3 of August 1980 pages 914—916.

The controller interface comprises a keyboard display interface circuit and a decoder.

The interface circuit provides the decoder with a scan code, on a plurality of scan lines.

The scan code is decoded in one signal over a plurality of column selection lines.

The signal is used to select a column of a keyboard matrix which provide the interface circuit with a binary code over a plurality of return line.

When a switch closure is detected by the interface circuit, it stores in an internal buffer a code corresponding to the closed switch and forwards an interrupt signal to a central processing unit which may be a microprocessor such as INTEL 8085.

When interrupt is acknowledged the code stored in the buffer is transferred to the microprocessor through the INTEL 8085 input/output bus.

The present invention obviates these disadvantages; it minimizes the complexity and the number of the circuits constituting the interface unit and provides for connecting such interface unit to the central unit through a minimum number of leads.

According to the present invention, both the complexity and number reduction of the circuits constituting the interface unit and drastic reduction, of the connection leads between the keyboard interface unit and the central processing unit are obtained: 1) by having the interface unit working simply as a scanning logic network for the keyboard keys; 2) by having the operations of actuated key acknowledgment and of character code association to the actuated key performed by, the central unit itself (in the prior art these operations were performed by the keyboard interface unit).

More in details, the central unit sends to the interface unit, through a first connection lead, a sequence of pulses. A scanning logic network in such interface unit evolves in response to such pulses.

At each received pulse, the interface unit sends to the central unit through a second connection lead, an answer signal, which has a predetermined logic level if the selected key is actuated or pressed.

When such answer signal points out a condition of actuated key, the central unit recognizes the particuar actuated key on the grounds of the number of pulses already sent to the interface unit and associates to it the related character code.

These and other features will appear more clearly from the following description of a preferred embodiment of the invention and from the accompanying drawings where:—

Fig. 1 shows in block diagram the architecture of a simple data processing system using the keyboard coding apparatus of the present invention;

Fig. 2 shows in black box form a microprocessor which may be suitably used as central unit in the data processing system of fig. 1;

Fig. 3 shows in detail the interface unit between the keyboard and the microprocessor of fig. 1 according the present invention;

Fig. 4 shows in flow diagram the operations executed by the microprocessor in order to scan the keyboard and to detect an actuated key;

Fig. 5 shows in flow diagram the operations executed by the microprocessor in order to detect the contemporary actuation of more keys.

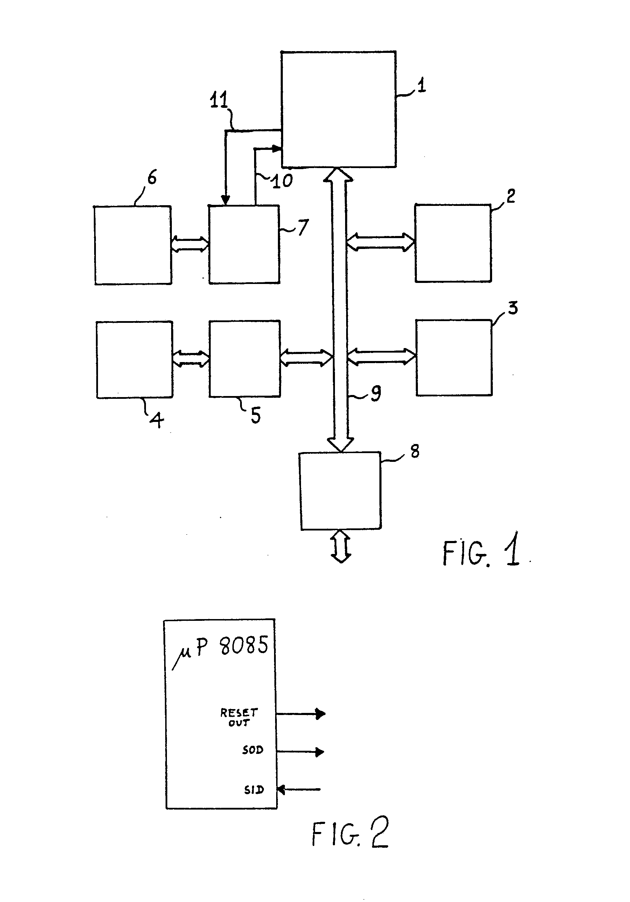

Fig. 1 shows in schematic block diagram the architecture of a simple data processing system using the keyboard coding apparatus object of the present invention.

For instance, such data processing system may be an intelligent terminal or a minicomputer.

The system of fig. 1 comprises a microprocessor 1, a read only memory 2 devoted to store the control programs (or microprograms) of microprocessor 1, a read/write working memory 3, an output device 4, an interface unit 5 devoted to control output device 4, a keyboard 6 and an interface unit 7 devoted to scan keyboard 6. In the following interface unit 7 will be named scanning interface too.

If the system of fig. 1 has to communicate and exchange information with an additional data processing system, as for example it occurs for an intelligent terminal, a communication interface 8 is provided.

Through such interface microprocessor 1 communicates with the data processing system to which the system of fig. 1 is connected.

As an example, the integrated circuit manufactured by INTEL with code 8251 may be used as communication interface. Such integrated circuit is broadly described by the manufacturer's manuals to which the readers may refer for additional information. Microprocessor 1 communicates in bidirectional way with control memory 2, working memory 3, control interface 5 and communication interface 8 through a group of leads 9 named BUS; besides microprocessor 1 communicates with scanning interface 7 through two leads 10, 11.

Microprocessor 1, when its resources are devoted to manage keyboard 6, executes a microprogram stored in control memory 2 and checks with a so-called "polling" technique the state of all the keys of keyboard 6 through scanning interface 7. In such a way microprocessor 1 checks if there is a key actuated, that is if there is a character to be treated.

In order to obtain a complete scanning of keyboard 6, the microprocessor 1 sends on lead 11 a number of pulses equal to the number of keys.

Each pulse sequentially locates a key of keyboard 6.

At each pulse sent, microprocessor 1 updates the content of an internal register of its owns and receives through lead 10 an answer signal representative of the state of the located key. If through such answer signal microprocessor 1 detects the condition of actuated key, it takes out the code related to such key from a code table stored for instance in working memory 3; more particularly it associates to the actuated key the content of a memory location whose address is stored in its already mentioned internal register containing the number of pulses sent up to that time on lead 11.

Fig. 2 shows in schematic form a microprocessor which may be suitably used in the embodiment of the invention.

The microprocessor in question is the μP 8085 manufactured by INTEL and broadly described in terms of architecture, functions, performances, and use conditions by the manufacturer's manuals, as for instance "MCS-80, User Manual (with introduction to MCS-85)", October 1977 and "8080/8085 Assembly Language Programming Manual", 1977.

For the purposes of the present invention it is sufficient to point out that μP 8085 has two communication pins connected to leads 10, 11 of fig. 1 and a control pin connected to all the interface units of the system of fig. 1 and therefore to scanning interface 7 too (this connection is not shown in fig. 1).

Such pins are=

—SID=it is an input pin allowing the microprocessor to receive serial input data. In particular the information on this pin is loaded into bit 7 of microprocessor accumulator whenever a RIM microinstruction is executed (such microinstruction is part of microinstruction set of μP 8085).
—SOD=it is an output pin allowing the microprocessor to transmit serial output data. In particular the information corresponding to bit 7 of microprocessor accumulator is loaded on such pin whenever bit 6 of the same accumulator is at logic level 1 and a SIM microinstruction is executed (such microinstruction is part of microinstruction set of μP 8085 too).
—RESET OUT: it is an output pin on which the microprocessor sends a signal to the other units of the system in order to set them in initialization phase.

Before going on, the simple routine by whose execution μP 8085 supplies a pulse on SOD pin is explained.

Such routine develops through the following steps:

a) microprocessor loads into accumulator an information having bits 6, 7 at logic level 1 by means of a first loading microinstructions;

b) microprocessor transfers logic level 1 of accumulator bit 7 on SOD pin by means of a first SIM microinstruction (this corresponds to the leading edge of the pulse);

c) microprocessor loads into accumulator an information having bit 6 at logic level 1 and bit 7 at logic level 0 by means of a second loading microinstruction;

d) microprocessor transfers logical level 0 of accumulator bit 7 on SOD pin by means of second SIM microinstruction (this corresponds to the trailing edge of the pulse).

As already mentioned, in order to check the state of each key of keyboard 6, μP 8085, just after having sent a pulse, loads into accumulator bit 7 the logic level present on SID pin by means of a RIM microinstruction.

By means of logic and jump microinstruction the microprocessor verifies if such logic level is 1 or 0 and therefore follows suitable branches in executing its program.

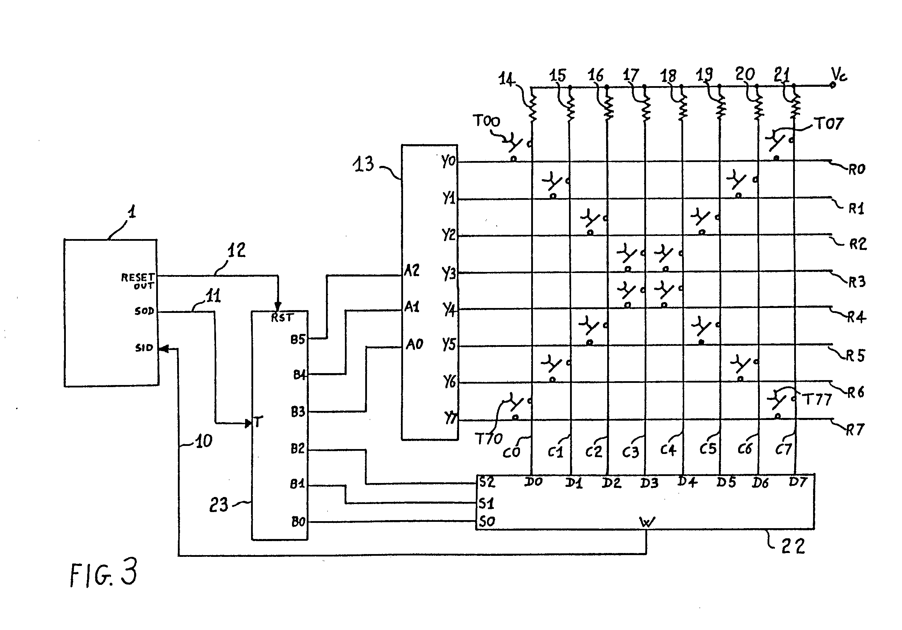

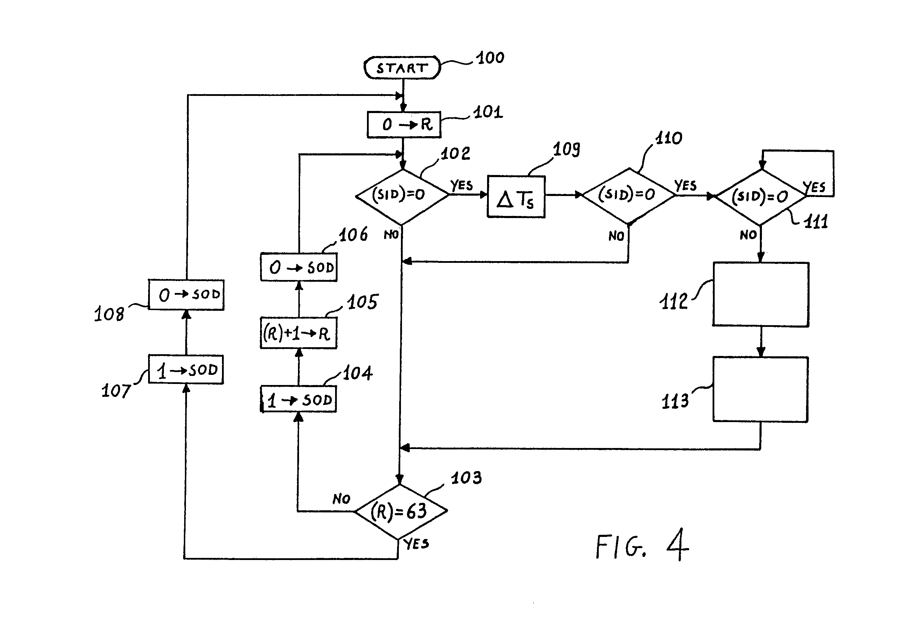

What above mentioned will result clearer from the analysis of figures 3 and 4.

Fig. 3 shows in detail scanning interface 7, keyboard 6 and the connection between such interface and microprocessor 1 where the invention is more properly located.

Keyboard 6, for instance of mechanical type with 64 keys, comprises a plurality of leads arranged according to a matrix of 8 rows R0, R1, ..., R7 and 8 columns C0, C1, ..., C7.

A key $T_ij$ is associated to each matrix point Pij ($0 \leq i \leq 7$, $0 \leq j \leq 7$) determined by the row lead i and by the column lead j; such key $T_ij$ if pressed, causes an electric continuity between the row lead i and column lead j.

Row leads R0, R1, ..., R7 are respectively connected to outputs Y0, Y1, ..., Y7 of a decoder 13 having 3 inputs and 8 outputs.

Column leads C0, C1, ..., C7 are connected on the one hand to a direct supply voltage $V_c$ through resistors 14, 15, ..., 21 respectively and on the other hand to inputs D0, D1, ..., D7 of a multiplexer 22 having 8 inputs and 1 output.

Selection inputs 50, 51, 52 of multiplexer 22 are respectively connected to the least significant outputs B0, B1, B2 of a 6 bit counter 23.

The most significant outputs B3, B4, B5 of counter 23 are respectively connected to inputs A0, A1, A2 of decoder 13.

Output w of multiplexer 22 is connected to SID pin of microprocessor 1 (μP 8085) through lead 10.

Increment input T of counter 23 is connected to SOD pin of microprocessor 1 through lead 11.

Besides, reset input RST of counter 23 is connected to RESET OUT pin of microprocessor 1 through lead 12.

The circuits constituting the scanning interface, that is counter 23, multiplexer 22 and decoder 13, do not require any particular explanation because they are well known to the people skilled in the art and generally available on the market as integrated circuits.

For instance integrated circuits 74LS251 and 74LS138 may be respectively used as multiplexer 22 and decoder 13; counter 23 may be carried out by means of 2 integrated circuits 74LS193 cascade connected.

All the mentioned integrated circuits are manufactured by TEXAS.

It is to be noted that 2 integrated circuits 74LS193 suitably cascade connected form a 8 bit binary counter: only the 6 last significant outputs are used because the described embodiment of the invention refers to a keyboard having 64 keys (in such a case a 6 bit counter is sufficient for a complete scanning of the keyboard).

The working of the scanning interface is very simple.

Let us suppose that outputs B5, B4, B3, B2, B1 of counter 23 have the starting binary configuration 000000.

This starting condition may be the result of both a cyclic operation of count and a general reset caused by an active signal on RESET OUT pin of microprocessor 1.

In such condition outputs B5, B4, B3 produce a logic and electric level 0 on output Y0 of decoder 13: row lead R0 may be therefore considered virtually connected to ground.

Besides outputs B2, B1, B0 of counter 23, connected to selection inputs $S_2$, $S_1$, $S_0$ of multiplexer 22, allow to transfer to multiplexer output w the logic/electric level present on column lead C0.

If key T00 associated to row lead R0 and to column lead C0 is pressed, a logic/electric level 0 is present on output w of multiplexer 22; on the contrary, if such key is not pressed, a logic/electric level 1 is present on output w.

When a pulse is sent to input T of counter 23, the counter outputs assume the configuration 000001.

In such condition it may be checked through decoder 13 and multiplexer 22 if the key associated to row lead R0 and to column lead C1 is pressed (output w of multiplexer at logic level 0) or not (output w at logic level 1).

Thus through a series of 63 pulses, it is possible to make a complete scanning of the keyboard keys, said scanning being made for subsequent rows of the matrix according to which the key are arranged.

Before considering the operations executed by microprocessor 1 in order to scan the keyboard and detect an actuated key, two problems arising in the use of a keyboard and which the microprocessor has to keep in consideration are briefly pointed out.

The first problem, which may be found in a keyboard of mechanical type, is the one due to the transient phenomena occurring as soon as a key Tij of the keyboard of fig. 3 is pressed. In fact key Tij does not immediately cause a stable condition of electric continuity between row lead i and column lead j, but, owing to the bounces of key Tij, such stable condition happens after an intial interval $\Delta T_0$. Interval $\Delta T_0$ depends on the type of mechanical keyboard used and generally has a duration of some milliseconds ($1 \div 2$ ms).

Because during such interval several keyboard scannings are performed it may happen that microprocessor 1, on checking the state of a key Tij, detects several times, owing to the initial bounces, the condition of actuated key Tij and consequently treat several times the character related to such key.

In order to avoid inconvenient, microprocessor 1 is compelled to work in the following way: as soon as it detects a pressed key, it stops for a time interval $\Delta T_s$, with $\Delta Ts > \Delta T_0$, and then again checks if such key is still pressed. Only if the condition of pressed key persists, the microprocessor acknowledges this condition and goes on to associate to the pressed key the related character code.

It is clear that the whole phase of pressed key acknowledgement must develop in the time interval during which the key remains in this condition. Such time interval depends on the typewriting speed of the operator and generally never is shorter than some tens of milliseconds ($20 \div 30$ ms).

In the present invention time interval $\Delta Ts$ has been suitably fixed equal to 10 ms in order to fulfil the above requirements.

The second problem in using a keyboard in the one related to the start of the phase during which the corresponding character code is associated to the pressed key.

If such phase starts as soon as a pressed key is acknowledged, it may happen that this key still continue remaining pressed when the operations related to such phase are completed, so causing an undesired repetition of operations related to the same key.

This inconvenient is avoided by making the mentioned phase start as soon as the key in question return to the non-pressed condition.

Fig. 4 shows in flow diagram the operations performed by microprocessor 1 in order to scan the keyboard and identify a pressed key.

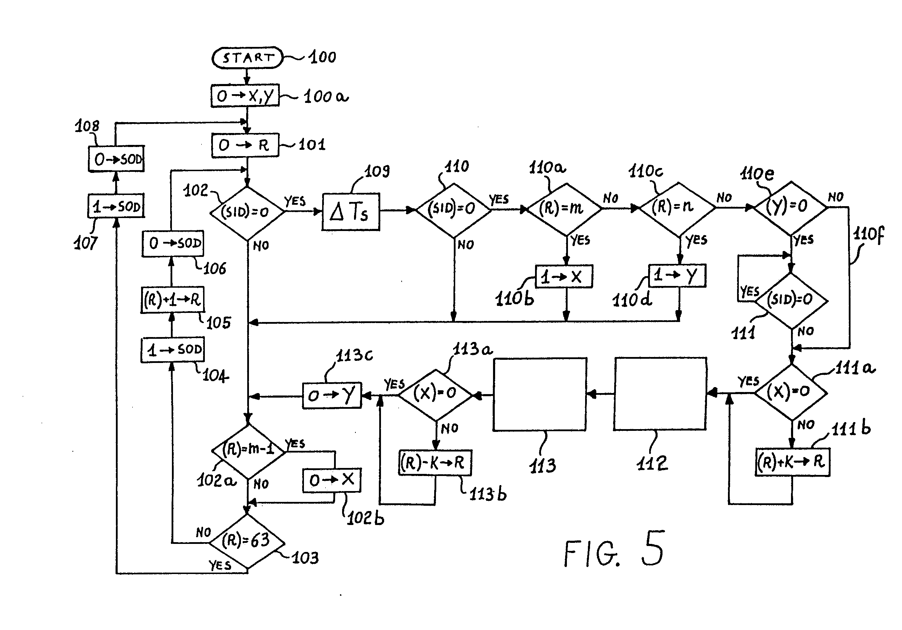

During the description of flow diagram of fig. 4, as well as of flow diagram of fig. 5, the expression "the microprocessor enters block i" will be sometimes met; such expression means that the microprocessor executes the operation described by block i.

The flow diagram of fig. 4 begins from START block 100 and continues by block 101 where the microprocessor resets an internal register R of its own and presets, through a RESET OUT command, the initial state of scanning interface 7.

Then the microprocessor checks the logic level of the signal present on its SID input (block 102), that is it initially checks if key T00 is pressed or not.

If the microprocessor detects that key T00 is not pressed [(SID)$\neq$0], it goes on to check if the content of its internal register R is equal to 63 (block 103), that is it checks if a keyboard scanning has been completed. If the content of register R is less than 63, the microprocessor raises to logic level 1 its SOD output (block 104), increments by one the content of its internal register R (block 105) and then again lowers to logic level 0 its SOD output (block 106).

The pulse so provided by the microprocessor increments by one the content of counter 23 of fig. 3.

As already seen, a signal indicative of the state of the key subsequent to the one previously checked is made available on SID input of microprocessor through counter 23, decoder 13 and multiplexer 22.

The microprocessor checks such signal (block 102) and, if this last one is at logic level 1 (that is the considered key is not pressed), goes on to scan the keyboard according to the loop comprising blocks 103, 104, 105, 106, 107.

At the end of a complete scanning the microprocessor detects that the content of its internal register R is equal to 63. It sends a further pulse (blocks 107, 108) on its SOD output so as to reset the outputs of counter 23 of fig. 3.

Then the microprocessor starts to scan again the keyboard by entering block 101.

If at a certain time microprocessor 1 detects (block 102) a key Tij pressed [(SID)=0] it enters a wait state of length $\Delta T_s = 10$ ms (block 109) obtainable for instance by making the microprocessor execute a predetermined number of NOP (No Operation) microinstructions.

Afterwards the microprocessor checks again the state of the considered key Tij (block 110).

If this time such key is not pressed [(SID)$\neq$0], microprocessor 1 enters again block 103.

If, on the contrary, microprocessor 1 detects that the key Tij in question is still pressed [(SID)=0], it acknowledges a real actuation of such key and enters block 111 waiting for key Tij to return to the non pressed condition.

As soon as microprocessor 1 detects that the considered key Tij is not pressed any longer [output (SID)$\neq$0 of block 111], it draws the character code associated to key Tij (block 112), said code being stored for example into working memory 3 of fig. 1 in a position whose address is provided by the content of microprocessor register R. After having performed a routine of character code treatment (block 113), as for instance the sending of commands for printing the character, the microprocessor enters again block 103.

It is to be noted that the program described by fig. 4 does not allow the microprocessor to detect the presence of several keys pressed at the same time, because the microprocessor stops to the first key pressed which it detects during a scanning and remains in such state until this key returns to the non pressed condition.

On the other hand most of the keyboards allows that some functions and characters are performed only if several keys are pressed.

For instance all the keyboards are provided with a "shift" key by means of which it is possible to associate two characters to the remaining keys (except for a few).

In other words, if the "shift" key is not pressed, a determinate character is associated to a key; if, on the contrary, the "shift" key is pressed, another character is associated to the key in question (for instance Capital letters).

Besides most of the keyboards are provided with a "repeat" key. If pressed, the "repeat" key allows a treatment repetition of the character associated to the key pressed just after such "repeat" key; the character is treated as long as the corresponding key remains pressed.

Fig. 5 shows in flow diagram the operations which microprocessor 1 must perform in order to acknowledge several keys pressed.

It is supposed that keyboard 6 of fig. 3 is provided with a "shift" key whose state microprocessor 1 checks after m pulses sent on line 11 and with a "repeat" key whose state microprocessor 1 checks after n pulses sent on line 11.

Besides it is supposed that, if the first character code associated to a determined key is stored into working memory 3 of fig. 1 at an address N, the second character code associated to the same key (when the "shift" key is pressed at the same time) is stored at an address N+K into the same memory.

It is to be noted that in fig. 5 the numeric references of fig. 4 are preserved for those blocks showing identical operations performed by the microprocessor; such blocks will not be described because this has already made during the description of fig. 4.

Referring to fig. 5, a block 100a is inserted between blocks 100 and 101. When the microprocessor enters block 100a, it resets two internal registers x, y of its own.

Registers x, y are required to latch the condition of the "shift" key and of the "repeat" key respectively; this will be seen later on.

It is to be noted that in fig. 5, before block 103, there is a block 102a where the microprocessor checks if it has tested the state of the key immediately before the "shift" key.

In negative case [(R)≠m—1] the microprocessor checks if the keyboard has been completely scanned (block 103).

In affirmative case [(R)=m—1] the microprocessor, before entering block 103, resets register x even if this last already was in reset state (block 102 b). So register x is reset at the end of each translated scanning (translated scanning means the scanning going from key m to key 63 and then from key 0 to key m—1): this must occur because the microprocessor only recognizes the "shift" key change from the non pressed state to the pressed one.

In fact it may happen that an operator press the "shift" key (in consequence of this, as it will be seen later on, the microprocessor loads a "1" into register x) and afterwards release such key without having made use of the "shift" function.

By means of blocks 102a and 102b, the pressed "shift" key condition is maintained latched for an only translated scanning; at the beginning of the subsequent translated scanning, if the microprocessor still detects the "shift" key pressed, it latches again such condition.

When the microprocessor acknowledges the real actuation of a key [output (SID)=0 of block 110], it enters the block 110 where it checks if the pressed key is the "shift" one.

In affirmative case [(R)=m], it stores such conditions into register x (block 110b) and enters block 102a.

In negative case [(R)≠m], it checks if the pressed key is the "repeat" one (block 110c).

If the microprocessor recognizes that the pressed key is the "repeat" one, it stores such condition into register Y (block 110d) and enters block 102a, otherwise it enters block 110e.

In such block the microprocessor checks if it had before stored the pressed "repeat" key condition: in negative case [(Y)=0] it enters block 111 (already described during the explanation of fig. 4), and then block 111a, otherwise [(Y)≠0] it enters at once block 111a through path 110f.

In block 111a the microprocessor checks if the pressed "shift" key condition is latched for the translated scanning in progress: in negative case [(X)=0] the microprocessor enters at once block 112 and then block 113, otherwise [(X)≠0] it adds to the content of register R the displacement K (block 111b) and enters block 112 and then block 113.

When the microprocessor finishes treating the drawn character code, it enters block 113a where it checks again if the pressed "shift" key condition is latched: in negative case [(X)=0] it enters at once block 113c where it removes the possible pressed "repeat" key condition by resetting register Y, even if this last was already reset; in affirmative case [(X)≠0] it provides to restore the old content into register R (block 113b) and then enters block 113c.

Then the microprocessor enters block 102a from block 113c.

It is to be noted from the analysis of the flow diagram of fig. 5 that, when an operator presses the "repeat" key and then a second key, the microprocessor soon draws and treats the character code associated to this second key; besides, if both the "repeat" key and such second key continue being pressed, the microprocessor continues drawing and treating the character code related to said second key for each keyboard scanning.

The repeating period of the coding apparatus of the present invention is therefore determined by the cycle of the keyboard scanning from the microprocessor.

It is clear that such repeating period may be suitably increased according to the requirements by inserting on path 110 of fig. 5 a block of wait ΔTr.

Flow diagrams of figures 4 and 5 may be easily translated in microprograms by a people skilled in the art, bearing in mind the instruction set of μP 8085.

Several changes may be made to the described keyboard coding apparatus without departing from the scope of the present invention.

For example, instead of μP 8085, any one of the other microprocessor provided with an input and an output, respectively devoted to receive and transmit serial data may be used (as for instance μP 2650 manufactured by Philips).

## Claims

1. Keyboard coding apparatus and related control equipment, of the kind where said apparatus comprises:

— a keyboard (6) having a plurality of keys arranged according to a matrix of C columns and R rows, each of said keys, when actuated, transferring an electrical signal between one of C column leads and one of R row leads,
— scanning means (7) connected to said column and row leads and selectively providing an electrical signal to a selected one of said row leads,

and is connected to said control equipment through interface leads, said control equipment comprising:

— a microprocessor (1) having an internal register, a serial input data pin (SID) and a serial output data pin (SOD), and
— memory means (2, 3) having a plurality of addressable locations, and storing the control programs of said microprocessor and character codes related to said keys at predetermined locations, characterized in that,
— said scanning means (7) has an input and an output respectively connected through an input interface lead (11) and an output interface lead (10) to said serial output data pin (SOD) and said serial input data pin (SID) said scanning means receiving input scan advance pulses from said microprocessor and providing as an output to said microprocessor, at each received pulse, a logic signal indicative of the actuated/non actuated state of a selected one of said keys, said microprocessor incrementing by one the content of said internal register at each scan advance pulse forwarded to said scanning means, addressing one of said predetermined locations of said memory means (2, 3) through the content of said internal register, if said logic signal indicates the actuated state of the selected key, and reading out from said addressed location the code related to the actuated key.

2. Keyboard coding apparatus and related control equipment as claimed in claim 1 further characterized in that said scanning (7) means comprises:

— counting means (23) having an increment input (7) and a first and a second group of outputs, said increment input (T) being the input of said scanning means;
— decoding means (13) having an input group connected to said first output group of said counting means and a plurality of outputs, each one connected to one of said R row leads of said keyboard;
— multiplexing means (22) having a plurality of inputs, each one connected to one of said C column leads of said keyboard, a selection input group connected to said second output group of said counting means (23) and an output (w), said output being the output of said scanning means.

## Patentansprüche

1. Tastaturkodiervorrichtung und zugehörige Steuereinrichtung mit

— einer Tastatur (6) mit in einer Matrix von C Spalten und R Zeilen angeordneten Tasten, von denen jede bei Betätigung ein elektrisches Signal zwischen einer der C Spaltenleitungen und einer der R Zeilenleitungen überträgt;
— einer an die genannten Spalten- und Zeilenleitungen angeschlossenen Abtastvorrichtung (7), welche selektiv ein elektrisches Signal an eine ausgewählte Zeilenleitung legt und über Schnittstellenleitungen an die Steuereinrichtung angeschlossen ist; wobei die Steuereinrichtung
— einen Mikroprozessor (1) mit internem Register, einem Seriendateneingangsstift (SID) sowie einem Seriendatenausgangsstift (SOD) und
— einem Speicher (2, 3) mit einer Vielzahl adressierbarer Speicherplätze aufweise, der die Steuerprogramme des Mikroprozessors sowie den Tasten zugeordnete Zeichencodes in vorgegebenen Speicherplätzen speichert, dadurch gekennzeichnet,

daß die Abtastvorrichtung (7) mit einem Eingang bzw. einem Ausgang über eine Eingangsschnittstellenleitung (11) und eine Ausgangsschnittstellenleitung (10) an der Seriendatenausgangsstift (SOD) und den Seriendateneingangsstift (SID) angeschlossen ist;

daß die Abtastvorrichtung vom Mikroprozessor Eingangsabtast-Fortschaltimpulse empfängt und als Ausgangssignal bei jedem empfangenen Impuls an den Mikroprozessor ein den Betätigungszustand einer ausgewählten Taste kennzeichnendes logisches Signal liefert; und

daß der Mikroprozessor bei jedem der Abtastvorrichtung zugeführten Abtastfortschaltimpuls den Inhalt des internen Registers um Eins erhöht, einen der vorbestimmten Speicherplätze des Speichers (2, 3) über den Inhalt des internen Registers adressiert, sofern das logische Signal die Betätigung der ausgewählten Taste anzeigt, und aus dem adressierten Speicherplatz den der betätigten Taste zugeordneten Code ausliest.

2. Tastaturkodiervorrichtung und zugehörige Steuereinrichtung nach Anspruch 1 ferner dadurch gekennzeichnet, daß die Abtastvorrichtung (7) folgende Baugruppen umfaßt:

—einen Zähler (23) mit einem Fortschalteingang (T) und einer ersten und zweiten Gruppe von Ausgängen, wobei der Fortschalteingang den Eingang der Abtastvorrichtung bildet;
—einen Decoder (13) mit einer Gruppe von Eingängen, die an die erste Gruppe von Ausgängen des Zählers angeschlossen sind und mit mehreren Ausgängen, von denen jeder an eine der R Zeilenleitungen der Tastatur angeschlossen ist;
—einen Multiplexer (22) mit mehreren Eingängen, von denen jeder an eine der C Spaltenleitungen der Tastatur angeschlossen ist, mit einer Gruppe von Auswahlleitungen, die an die zweite Gruppe von Ausgängen des Zählers (23) angeschlossen sind, und mit einem Ausgang (w), der den Ausgang der Abtastvorrichtung bildet.

**Revendications**

1. Dispositif codeur de clavier et dispositif de commande associé, du type où ce dispositif codeur comprend:

—un clavier (6) comportant un ensemble de touches disposées selon une matrice de C colonnes et de R rangées, chacune des touches transférant, quand elle est actionnée, un signal électrique entre un des C conducteurs de colonnes et un des R conducteurs de rangées,
—un moyen d'exploration (7) connecté aux conducteurs de colonnes et de rangées et fournissant sélectivement un signal électrique à un conducteur sélectionné desdits conducteurs de rangées,

et où il est connecté au dispositif de commande par l'intermédiaire de conducteurs d'interface, ledit dispositif de commande comprenant:

—un microprocesseur (1) comportant un registre interne, une broche de données d'entrée en série (SID) et une broche de données de sortie en série (SOD), et
—des mémoires (2, 3) comportant un ensemble d'emplacements addressables, et agencées pour mémoriser les programmes de commande du microprocesseur et les codes de caractères relatifs aux touches à des emplacements prédéterminés, caractérisé en ce que:

—ledit moyen d'exploration (7) comporte une entrée et une sortie respectivement connectées par un conducteur d'interface d'entrée (11) et un conducteur d'interface de sortie (10) à ladite broche de données de sortie en série (SOD) et à ladite broche de données d'entrée en série (SID), le moyen d'exploration recevant des impulsions d'entrée de progression d'exploration du microprocesseur et fournissant comme signal de sortie au microprocesseur, à chaque impulsion reçue un signal logique indiquant l'état actionné/non actionné d'une touche sélectionnée desdites touches, le microprocesseur faisant progresser de un le contenu de registre interne à chaque impulsion de progression d'exploration envoyée au moyen d'exploration, adressant un des emplacements prédéterminés des mémoires (2, 3) par le contenu du registre interne, si ledit signal logique indique l'état actionné de la touche sélectionnée, et lisant à l'emplacement adressé le code relatif à la touche actionnée.

2. Dispositif codeur de clavier et dispositif de commande associé selon la revendication 1, caractérisé en outre en ce que ledit moyen d'exploration (7) comprend:

—un moyen de comptage (23) comportant une entrée de progression (T) et un premier et un second groupe de sorties, l'entrée de progression étant l'entrée du moyen d'exploration;
—un moyen de décodage (13) comportant un groupe d'entrées connectées au premier groupe de sorties du moyen de comptage et un ensemble de sorties, chacune étant connectée à un conducteur des R conducteurs de rangées du clavier;
—un moyen de multiplexage (22) comportant un ensemble d'entrées, chacune étant connectée à un conducteur des C conducteurs de colonnes du clavier, un groupe d'entrées de sélection connectées au second groupe de sorties du moyen de comptage (23) et une sortie (w), cette sortie étant la sortie du moyen d'exploration.

FIG. 1

FIG. 2

1

FIG. 3

0 064 627

FIG. 4

FIG. 5